# EUROPEAN PATENT SPECIFICATION

(11) **EP 3 637 007 B1**
(45) Date of publication and mention of the grant of the patent: **28.02.2024**
(21) Application number: 19201779.6
(22) Date of filing: 07.10.2019
(51) Int. Cl.: H01H 19/00, H01H 25/00, H05K 1/00, F24F 11/50, F24F 11/52, G05G 1/08, H01H 19/14, H01H 9/12, F24F 11/88, H05F 3/02, H05K 1/02

(54) **A ROOM CONTROLLER COMPRISING A ROTATABLE MEMBER**
RAUMSTEUERGERÄT MIT EINEM DREHBAREN ELEMENT
THERMOSTAT DE PIÈCE COMPRENANT UN ÉLÉMENT ROTATIF

(30) Priority: 09.10.2018 FI 20185845
(43) Date of publication of application: 15.04.2020
(73) Proprietor: Produal Oy, 48770 Kotka (FI)
(72) Inventor: Ilmasti, Aki, 02650 ESPOO (FI); Hakkarainen, Petri, 40400 JYVÄSKYLÄ (FI); Uusitalo, Jyrki, LOHJA (FI)
(74) Representative: Berggren Oy

(56) References cited:
- JP-A- H08 315 660
- JP-A- H11 144 922
- JP-A- 2008 071 589
- JP-A- 2008 152 967
- US-A1- 2009 059 459
- US-A1- 2012 130 547
- US-B1- 6 229 103

## Description

### Technical field

The invention relates to a room controller for controlling adjustments of environmental conditions.

### Background

Room controllers are used to control and adjust environmental conditions, like thermal conditions and air quality. An example of room controllers are thermostats. Room may refer to one or more rooms, indoors or alike interiors, for example of homes, apartments, constructions, public buildings, cottages, cabins, portable buildings/interiors or transportation means. A room controller may comprise a rotatable member or a knob, which may be adjusted by a user in order to adjust and control thermal conditions of an environment within a building or a structure. A room controller may comprise a display for displaying information. The display may be placed inside the rotatable knob. A rotatable knob with a display, which is arranged to present the current information and adjustment(s), enables easy and self-directive use of the room controller.

US6229103 presents an operation knob with rotating and push operations. Grounding of the knob is implemented via separate grounding parts arranged between a live current portion and the knob enabling static electricity occurring in the operation knob to be conducted to the ground.

Document JP H11 144922 A discloses a controller comprising a circuit board and a rotatable member suitable for controlling adjustment of environmental conditions, wherein the rotatable member is rotatably connected to the circuit board via a support member which is attached to the circuit board, wherein the support member comprises conductive material, wherein the support member is joined to the ground of the circuit board and wherein the rotatable member is grounded via the support member.

### Summary

Object of the invention is to provide a reliable room controller, which is comfortable to use and handle. One object is to enable use of metal parts in a room controller. The invention is set out in the appended set of claims.

A rotatable member provides easy and handy user interface enabling controlling adjustment(s) in an untutored, self-directive way. In order to provide a reliable and safe working room controller, relationship, effects and connections between parts of the room controller are taken into account. For example, a rotating member may induce static electricity. Further, it is desired to freely select materials of parts and components.

A rotatable member may comprise or be comprised of metal. The rotatable member may induce or form a source of a static electricity. A metal part of a rotatable member of a room controller may cause sudden flow of electricity between the room controller and a user or other electrically charged object. Static electricity may cause defects, malfunctioning or breaking of other parts of a room controller. For example, electric parts on a circuit board and a display are vulnerable to static electricity. In order to avoid such defects and uncontrolled static electricity, a rotatable member is grounded.

A room controller comprises a rotatable member for controlling adjustment(s) of the thermostat, wherein the rotatable member is rotatably connected to a circuit board of the room controller via a support member comprising conductive plastic. The rotatable member may comprise metal. The conductive plastic enables providing a safe and secure grounding for the rotatable member.

### Brief description of the drawings

Embodiments of the invention are described in more detail with the accompanying figures, in which
- Figure 1: illustrates an existing room controller comprising a rotatable member.
- Figure 2: illustrates a rotatable member and a circuit board for a room controller.
- Figure 3: illustrates a rotatable member and a circuit board for a room controller.
- Figure 4: illustrates a room controller comprising a rotatable member and a display.
- Figure 5: illustrates rotation members for a room controller.
- Figure 6: illustrates a mechanical position detection for a rotation member.

### Detailed description

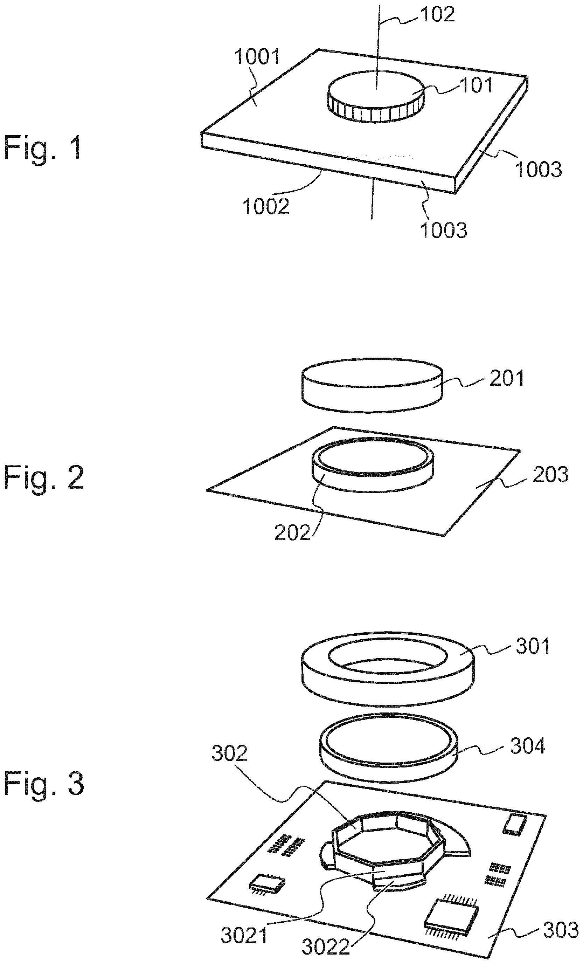

Figure 1 illustrates a room controller 100 comprising a rotatable member 101, but is not a part of the invention. The room controller 100 comprises a housing, which may be designed to have any suitable form, like a round, an oval, a square or other form different from a rectangular as illustrated in Figure 1. The housing comprises a back surface 1002 and a front surface 1001, separated from each other by side surface(s) 1003. The rotatable member 101 may protrude or project outward from the front surface 1001 of the room controller and/or the rotatable member 101 may comprise a gripping surface. Protrusion and/or gripping surface of the rotatable member 101 enables a user to rotate the rotatable member. The gripping surface may comprise a form, material or a prepared surface for enabling gripping by a user. The rotatable member 101 enables controlling adjustment(s) of the room controller 100 mechanically. User may adjust environmental conditions by rotating the rotatable member 101. The rotatable member 101 is arranged to rotate around rotating axis 102, which is perpendicular to the front surface 1001 of the rotatable member 101 and/or of the room controller 100. The rotatable member 101 has positions along its rotational motion and a desired parameter value is identified by the position of the rotatable member 101, or by the change of the position.

A rotatable member may comprise conductive material. The rotatable member may be made of conductive material. The rotatable member may comprise a portion, a circular part or a coating of conductive material. Conductive material may be electrically conductive and permit motion of electric charge through its volume. Conductive material may comprise metal, titanium, steel, aluminium, silver, chrome, gold, copper, platinum, tin, cobalt, iron, conductive ceramic, conductive plastic, or other conductive material, and/or a mixture comprising such.

Figure 2 illustrates a rotatable member 201 and a circuit board 203. The circuit board 203 may be fixed to a back surface or a base part of a housing of a room controller. Electronic components are connected to one or more circuit boards of the room controller. Electronic components and one or more circuit boards are housed by the room controller housing. The rotatable member 201 is arranged to rotate in relation to the circuit board 203 and in relation to the room controller housing. The rotatable member 201 is rotatably connected to the circuit board 201 via a support member 202. The rotatable member 201 is rotatably connected to a support member 202, which is mounted to the circuit board 203. The support member 202 is non-rotatable. The support member 202 comprises conductive plastic and is arranged to ground the rotatable member 201. The rotatable member 201 may comprise conductive material, like metal, which may form a source of induced static electricity. Rotating of the rotatable member 201 may create static electricity, frictional electricity or electric charging. The rotatable member 201 is rotatably connected to the support member 202 such that the two are arranged at least partly in contact. External surface of the support member 202, or parts of it, are arranged to contact internal surface of the rotatable member 201, at least partly. Contact surfaces of the members 201, 202 are arranged to slide in relation to each other. Electrons may be exchanged between the rotatable member 201 and the support member 202 arranged in contact with each other. Electrical charges may move between contact surfaces of the rotatable member 201 and the support member 202 in order to equalize their electro(chemical) potential. This creates net charge imbalance between the contact surfaces. Imbalance or charge remains until it is able to uncharge, for example by means of electric current or electrical discharge. Uncharging may cause a sudden flow of electricity from a room controller or metallic part. In order to avoid uncontrolled electrical discharges or electric currents, the rotatable member 201 is grounded via the support member 202, to the ground on the circuit board 203. The support member 201 may electrically shield electronic components of the circuit board 203.

A support member comprises or is made of conductive plastic. Conductive plastic may comprise conductive polymers or intrinsically conducting organic polymers having ability to conduct electricity. A polymer may comprise conductive substance(s), for example carbon. Conductive plastic may comprise polycarbonates (PC), acrylonitrile butadiene styrene (ABS), polyoxymethylene (POM), polyamides (PA) or any mixtures comprising any of such. Conductive plastic may comprise polyanilines (PANI), polyacetylenes (PAC), polypyrroles (PPY), polyindole or their copolymers. Conductive plastic may comprise poly(fluorene)s, polyhenylenes, polypyrenes, polyazulenes, polynaphthalenes, poly(p-phenylene vinylene) (PPV), polycarbazoles, polyazepines, poly(thiophene)s (PT), poly(3,4-ethylenedioxythiophene) (PEDOT) or poly(p-phenylene sulphide) (PPS). A support member comprising conductive polymer or plastic enables protecting and/or shielding against electromagnetic interference (EMI) and electrostatic discharge (ESD).

Figure 3 illustrates a rotatable member and a circuit board for a room controller. A rotatable member 301 forms a rotatable knob of a room controller, which enables user to adjust environmental conditions by rotating the knob. Use of conductive material, like metal, as part of the room controller, for example in cylindrical shell surface of the rotatable member 301, may have positive effect on user experience, visual experience, touch feedback, robustness, rigidity and/or design of a room controller. A rotatable member 301 comprises a cylindrical shell surface which is arranged at least substantially perpendicular with the front surface of the room controller. An upper or external end surface of the cylindrical rotatable member 301 may be open ended or closed by a lid surface. Another component may be situated in the middle of an open ended cylindrical rotatable member 301. For example a display may be situated in place of the upper lid of the cylindrical rotatable member 301. Thus the display may form an external surface of the room controller and be surrounded by the rotatable member. A lower or a base end surface of the cylindrical rotatable member 301 is open, without a lid surface. A lower end of a cylindrical rotatable member 301 is placed towards a circuit board 303.

A rotatable member 301 may comprise a hollow cylindrical structure, a circular edge portion, a ring or some other form or shape. The rotatable member 301 is shaped so that the rotatable movement of it is enabled. A structure of the rotatable member 301 may comprise straight, angulated or rounded cylindrical surface. The rotatable member 301 may comprise a form of a truncated cone, or of a convex cylindrical shell. The rotatable member 301 may comprise a ring, a portion, a coating and/or a cylindrical shell of conductive material. The conductive material of the rotatable member 301 may comprise metal, ceramic or other conductive material.

The rotatable member 301 is rotatably attached to a support member 302, which is attached to a circuit board 303. A support member 302 may be fixedly attached to a circuit board 303 via mechanical and/or adhesive connection(s). Mechanical connection may comprise screw, rivet, snap lock, or other mechanical connections. Adhesive connection may comprise adhesive, paste, cement or alike bonding agent. The support member 302 may be grounded or joined to a ground via the connection(s). The support member 302 comprises an external side surface 3021, which is arranged at least partly to correspond to form of the internal cylindrical surface of the rotatable member 301. The support member 302 may comprise a continuous circular portion, like a ring. The support member 302 may comprise an O-shaped structure, a U-shaped structure or a J-shaped structure, for example. The structure of the support member 302 may be formed of gear- or tooth-like portions, or triangular-, square-, line-, or bar-like portions. The portions may have angled or rounded shape. The portions are arranged to form a fixed counter part for the rotatable member 301, against which the rotatable member 301 is, at least partly, arranged in a sliding connection via connection surfaces. The support member 302 of Figure 3 is made of rectangular portions, which are arranged next to each other in order to form a continuous circle or ring structure. Instead of a closed or continuous structure, the support member may comprise an open or a discontinuous structure. The support member is connected to a ground via more than one connection points or places. The support member 302 or portions of it may protrude upwards from the circuit board 303, perpendicular to a surface of the circuit board 303. The circuit board 303 may be next to and/or parallel with a back surface of the room controller housing. Thus, the support member 302 may extend between back and front surfaces of the room controller housing.

Portions of the support member 302 may be arranged next to each other in order to form a continuous or a discontinuous structure. A structure or portions departing from a continuous closed ring may enable flexibility to the structure and placement of the support member 302, as well as other components on a circuit board 303. Structure of the support member 302 enables fitting wide areas of contact surfaces 3021, 3022 next to and in contact with the rotatable member 301. External surface area(s) 3021 of the support member 302, which is/are extending between the circuit board 303 and the front surface of the room controller housing, may be arranged in contact with the inner surface of the rotatable member 301. Surface area(s) 3022 of the support member, which is/are arranged next to the circuit board 303 and parallel with the circuit board 303 surface plane, may be arranged in contact with the lower end surface of the rotatable member 301. The rotatable member 301 is arranged to rotate in relation to the fixed support member 302, while in contact with the sliding contact surfaces 3021, 3022. The rotatable member 301 is grounded to the circuit board 303 via the support member 302. The circuit board 303 may comprise processor(s), sensor(s), integrated circuit(s), and other components attached thereto. At least some or all of the electric component may be shielded by the support member 302 on the circuit board 303. For example components that are sensitive to a radio frequencies and/or transmitting radio frequency, may be shielded via support member 302. The support member 302 may have effect of protecting and/or shielding the components attached to the one/more circuit board(s) of the room controller.

A room controller may comprise parts and/or components capable of forming a wireless connection. The parts and/or component may have remote access to, or receive data from an external sensor, for example. A radio frequency (RF) block of a room controller may be shielded against interferences. The support member 302 may provide an integrated ESD and EMI shield, including an RF shield, for the room controller.

A room controller may comprise a coder ring 304, which is rotatable. The coder ring 304 may be arranged to rotate with the rotatable member 301. The coder ring 304 may be an integral part of the rotatable member 301, or a separate part connectable to it, for example next to internal surface of the rotatable member 301. The coder ring 304 may form, at least partially, an inner cylindrical surface of the rotatable member 301. The coder ring 304 may be arranged at least partly in contact with the support member 302. The coder ring 304 comprises conductive material. The conductive material of the coder ring 304 may comprise similar conductive materials as the support member 302. Since a sliding contact surface(s) are arranged between the support member 302 and the coder ring 304, conductive materials of the two may differ from each other. Use of the same conductive material on the sliding contact surface(s) may lead to wearing of materials. Thus the conductive materials used are selected such that the materials enable forming workable and wear resistant sliding contact surfaces between the support member 302 and the coder ring 304. The rotatable member 301 and the coder ring 304 are grounded via support member 302.

The support member 302 may comprise external surface areas 3021, 3022 arranged at least partly in contact with the surface of the coder ring 304. The surfaces may be arranged in contact such that the coder ring 304 is arranged in a sliding and rotatable contact with the support member 302. The support member 302 may comprise vertical 3021 and/or horizontal 3022 contact surfaces. The contact surfaces 3021, 3022 may be adapted to be in contact with an internal cylindrical surface of the rotatable coder ring 304. The contact surfaces 3021, 3022 of the support member 302 that are arranged to contact with the coder ring 304 may be called a contact surface, a sliding surface or a sliding contact surface. The contact surface enables the rotatable member 301 to be rotated in relation to the support member 302, while the rotatable member 301 is remained in contact with the support member 302. This enables large contact surface between the rotatable member 301 and the support member 302. This enables safe and secure ground connection of the rotatable member via the sliding surface area. Safe and secure ground connection provides safe and secure shielding against ESD and EMI.

In an alternative construction, an external conductive part of the room controller may be fixed, non-movable. The external conductive part may be a metal ring attached to a housing of the room controller. A rotatable member may rotate between the fixed external conductive part and the support member. A rotatable member may comprise an external gripping surface in order to enable rotation of it by a user. In this alternative construction, the rotatable member as well as the fixed external conductive part are grounded via the support member.

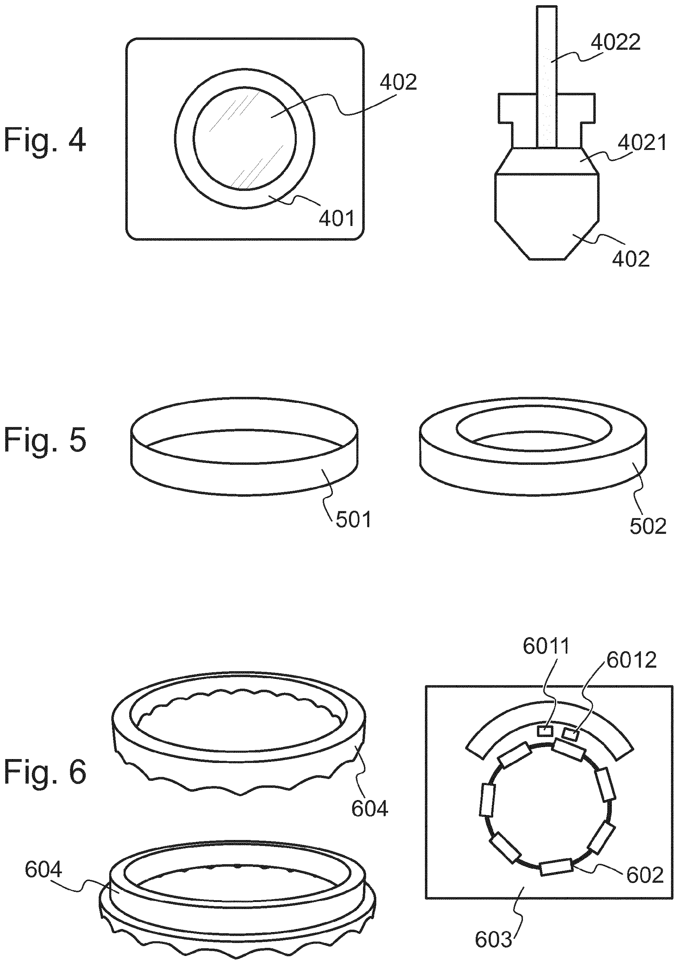

Figure 4 illustrates a room controller according to an embodiment. The room controller is shown at its front surface and it comprises a rotatable member 401 and display 402. A display 402 is placed in the middle of the rotatable member 401. The display 402 may be covered by a surface component, which may comprise glass or plastic, for example. The external surface of the display 402 and the rotatable member 401 surrounding it may be placed at least approximately at the same level above the front surface of the room controller. The rotatable member 401 may comprise a gripping surface arranged parallel with and/or perpendicular to the front surface of the room controller housing.

The display 402 is illustrated separately next to a room controller in Figure 4. The display 402 may comprise a liquid crystal display. The display 402 may comprise a display driver 4021 for controlling the display and electrical connections 4022 for electrically connecting the display, for example to a circuit board. The electrical connections 4022 may comprise flexible connections. A display driver 4021 may be part of a display module or separate from it, attached to a circuit board or next to the display 402. A display 402, a display driver 4021 and/or connections 4022 of the display 402 may be shielded by a support member, which is fixedly attached to a circuit board.

A display is arranged to present adjustment(s) of a room controller. A display is non-rotatably and electrically connected to a circuit board of a room controller. A rotatable member may form a continuous surround portion for a display placed at the front surface of a room controller housing. The display is non-rotatable and the rotatable member is rotatable in relation to the display.

Figure 5 illustrates alternative rotatable members. A rotatable member may comprise a circular surface portion 501, which corresponds to a form and thickness of a cylindrical shell of the rotatable member. The circular surface portion 501 and/or cylindrical shell portion may comprise slots or alike form in order to provide a surface for gripping for a user. A rotatable member may comprise a surface portion 502 inverted inwards from a cylindrical shell portion in order to form a partial lid surface, which may surround an open middle portion. The partial lid surface may be inverted slightly upwards or downwards from the cylindrical shell edge.

A circuit board may comprise a printed circuit board or a printed wired board. A thermostat may comprise one or more circuit boards. A circuit board may be single-sided or double-sided and/or multi-layered. The circuit board is arranged to electrically connect electronic components and support those mechanically. Electronic components may be mounted via through hole or be surface mounted to a circuit board.

Position of the rotatable member may be identified. Position detection may comprise electrical, optical, mechanical or magnetic means for detecting and sensing position. Mechanical position detection is based on detecting mechanical movement of the rotatable ring. As an example, a gear tooth structure or alike may be provided. A potentiometer, encoder or other suitable means may be used for converting mechanical position of the rotatable member to a corresponding electrical signal. Magnetic position detection is based on detecting magnetic changes, like change of polarity, magnetic resistance. For example, a magnetic ring may be placed inside the rotating member and rotation of it may be detected by a sensor. A mechanical position detection may have effect of causing less electrical or magnetic interference compared to electrical or magnetic position detection. A mechanical position detection may be less sensitive to interferences than electrical or magnetic ones.

Figure 6 illustrates mechanical position detection for a rotation member. Switches 6011, 6012 are joined to a circuit board 603. The switches 6011, 6012 are situated next to a support member 602 along a rotational moving path of a cylindrical shell edge of a rotating member or a coder ring 604. The cylindrical shell edge of the rotating member or the coder ring 604, that is insertable against and/or towards the circuit board 603, comprises a toothed edge surface, or projections or forms departing from even surface. Two separate, different kind of coder rings 604 are illustrated in Figure 6. The upper coder ring 604 comprises cylindrical cell of equal thickness, while the lower coder ring 604 comprises thicker toothed lower edge compared to the cylinder cell thickness of it. The lower coder ring 604 enables wider toothed area next to and towards the circuit board 603. The toothed edge surface enable detecting positional steps or phases of rotational movement via switches 6011, 6012. Any one of the switches 6011, 6012 may be used to detect rotation position. An encoder may be used for converting mechanical position of the rotatable member to a corresponding electrical signal. Counting pulses of a generated output signal enables determining position of the rotatable member.

Rotation direction of the rotatable member may be determined using two switches 6011, 6012.

A separate coder ring enables detecting rotational place of a rotatable member mechanically. The mechanical position detection may be implemented with less electronic components compared to e.g. electrical or magnetic position detection. Electronic components may be sensitive and/or source of interference. A separate coder ring enables utilization of complex forms, for example a toothed surface for position detection. If a sole rotating member, without a coder ring, is used, different kind of position detection may be em ployed.

In the description specific terminology is employed for the sake of clarity. The invention, however, it is not intended to be limited to the specific terminology so selected. Thus, it is to be understood that each specific element includes all technical equivalents that operate in the same or similar manner to accomplish the same or similar functions as long as within the scope of the claims.

It is to be understood that the foregoing description is intended to illustrate and not to limit the scope of the invention, which is defined by the scope of the appended claims. Other embodiments or variations may be within the scope of the following claims. Various non-limiting embodiments described and claimed herein may be used separately, combined or selectively combined for specific applications as long as within the scope of the claims. Further, some of the various features or parts of the above non-limiting embodiments may be used alone and/or replaced by another as long as within the scope of the claims. The foregoing description should therefore be considered as merely illustrative of the principles, teachings and embodiments of this invention, and not in limitation thereof, the invention being defined in the claims.

## Claims

1. A room controller comprising
a circuit board (203) and a rotatable member (201, 301) for controlling adjustment(s) of environmental conditions, wherein the rotatable member (201, 301) is rotatably connected to the circuit board (203) via a support member (202) comprising sliding contact surfaces comprising an external side surface (3021) that is arranged in contact with the rotatable member (301) and/or with a coder ring (304) arranged to rotate with the rotatable member (301), in relation to the support member (302), wherein the coder ring (304) is arranged between the rotatable member (301) and the support member (302), and which said external side surface (3021) is configured at least partly to correspond to a form of the internal cylindrical surface of the rotatable member (201, 301), and which support member (202) is attached to the circuit board (203),
wherein the support member (202) comprises conductive plastic, wherein the support member (202) is joined to the ground of the circuit board (203), and
wherein the rotatable member (201, 301) is grounded via the support member (202).

2. A room controller according to claim 1, wherein the rotatable member (201) comprises conductive material, optionally a portion, a circular part or a coating of conductive material.

3. A room controller according to claim 1 or 2, wherein the grounded rotatable member (201, 301) provides a shield for electromagnetic interference and electrostatic discharge.

4. A room controller according to claim 1, wherein the coder ring (304) comprises conductive material, optionally conductive plastic different from the conductive plastic of the support member.

5. A room controller according to any of claims 1-4, wherein rotational position detection of the rotatable member (301) is implemented via a coder ring (304).

6. A room controller according to any of claims 1-5, wherein the rotatable member (201) and the support member (202) are arranged at least partially in contact, optionally via a coder ring (304), such that the contact provides grounding of the rotatable member (201) via the support member (202), while enabling rotation of the rotatable member (201) in relation to the support member (202).

7. A room controller according to any of claims 1-6, wherein the support member comprises vertical and horizontal external surface area(s) arranged to form sliding contact surfaces (3021, 3022), which are arranged at least partly in contact with at least portions of a cylindrical internal surface and an edge surface of the rotatable member (301) or of a coder ring (304).

8. A room controller according to any of claims 1-7, comprising a display (402) for presenting the adjustment(s) of the room controller, wherein the display (402) is non-rotatably connected to the room controller and electrically connected to the circuit board of the room controller.

9. A room controller according to claim 8, wherein the display (402) comprises a display driver and electrical connections, wherein the display (402), the display driver and/or electrical connections are shielded by the support member.

10. A room controller according to any of claims 1-9, wherein the room controller is a thermostat.

11. A room controller according to any of claims 1-10, comprising a rotation detection system configured to mechanically sense rotation of the rotatable member (301).

12. A room controller according to any of claims 1-11, comprising a circular conductive part fixed to a housing of the room controller and arranged at least partly around the rotatable member (201), such that the rotatable member (201) is arranged at least partly between the conductive part and the support member (202).

13. A room controller according to any of claims 1-12, wherein electrical components of the circuit board (203, 303) are arranged to be shielded by the support member (202, 302).

14. A room controller according to any of claims 1-13, wherein the support member provides a shield for electromagnetic interference (EMI) and electrostatic discharge (ESD), and a shield for radio frequency components.

## Patentansprüche

1. Raumsteuergerät, umfassend
eine Leiterplatte (203) und ein drehbares Element (201, 301) zum Regeln einer Anpassung(en) von Umgebungsbedingungen,
wobei das drehbare Element (201, 301) drehbar über ein Trägerelement (202) mit der Leiterplatte (203) verbunden ist, welches Gleitflächen umfasst, die eine außenseitige Fläche (3021) umfassen, die in Kontakt mit dem drehbaren Element (301) und/oder mit einem Codiererring (304) angeordnet ist, welcher angeordnet ist, um sich mit dem drehbaren Element (301), in Bezug auf das Trägerelement (302) zu drehen, wobei der Codiererring (304) zwischen dem drehbaren Element (301) und dem Trägerelement (302) angeordnet ist, und wobei die außenseitige Fläche (3021) konfiguriert ist, um mindestens teilweise einer Form der zylindrischen Innenfläche des drehbaren Elements (201, 301) zu entsprechen, und wobei das Trägerelement (202) an der Leiterplatte (203) befestigt ist,
wobei das Trägerelement (202) leitfähigen Kunststoff umfasst, wobei das Trägerelement (202) mit dem Boden der Leiterplatte (203) verbunden ist, und
wobei das drehbare Element (201, 301) über das Trägerelement (202) geerdet ist.

2. Raumsteuergerät nach Anspruch 1, wobei das drehbare Element (201) leitfähiges Material umfasst, optional einen Abschnitt, ein kreisförmiges Teil oder eine Beschichtung aus leitfähigem Material umfasst.

3. Raumsteuergerät nach Anspruch 1 oder 2, wobei das geerdete drehbare Element (201, 301) eine Abschirmung für elektromagnetische Störung und elektrostatische Entladung bereitstellt.

4. Raumsteuergerät nach Anspruch 1, wobei der Codiererring (304) leitfähiges Material, optional leitfähigen Kunststoff umfasst, der sich von dem leitfähigen Kunststoff des Trägerelements unterscheidet.

5. Raumsteuergerät nach einem der Ansprüche 1-4, wobei Drehpositionserkennung des drehbaren Elements (301) über einen Codiererring (304) implementiert wird.

6. Raumsteuergerät nach einem der Ansprüche 1-5, wobei das drehbare Element (201) und das Trägerelement (202) mindestens teilweise, optional über einen Codiererring (304) in Kontakt angeordnet sind, sodass der Kontakt eine Erdung des drehbaren Elements (201) über das Trägerelement (202) bereitstellt, und dabei gleichzeitig eine Drehung des drehbaren Elements (201) in Bezug auf das Trägerelement (202) ermöglicht.

7. Raumsteuergerät nach einem der Ansprüche 1-6, wobei das Trägerelement (einen) vertikale(n) und horizontale(n) Außenflächenbereich(e) umfasst, der (die) angeordnet ist (sind), um Gleitflächen (3021, 3022) zu bilden, die mindestens teilweise in Kontakt mindestens mit Abschnitten einer zylindrischen Innenfläche und einer Kantenfläche des drehbaren Elements (301) oder eines Codiererrings (304) angeordnet sind.

8. Raumsteuergerät nach einem der Ansprüche 1-7, umfassend eine Anzeige (402) zum Darstellen der Anpassung(en) des Raumsteuergeräts, wobei die Anzeige (402) nicht drehbar mit dem Raumsteuergerät verbunden ist, und elektrisch mit der Leiterplatte des Raumsteuergeräts verbunden ist.

9. Raumsteuergerät nach Anspruch 8, wobei die Anzeige (402) einen Anzeigetreiber und elektrische Verbindungen umfasst, wobei die Anzeige (402), der Anzeigetreiber und/oder elektrische Verbindungen durch das Trägerelement abgeschirmt sind.

10. Raumsteuergerät nach einem der Ansprüche 1-9, wobei das Raumsteuergerät ein Thermostat ist.

11. Raumsteuergerät nach einem der Ansprüche 1-10, umfassend ein Dreherkennungssystem, das konfiguriert ist, um eine Drehung des drehbaren Elements (301) mechanisch abzutasten.

12. Raumsteuergerät nach einem der Ansprüche 1-11, umfassend ein kreisförmiges drehbares Teil, das an einem Gehäuse des Raumsteuergeräts befestigt ist, und mindestens teilweise um das drehbare Element (201) herum angeordnet ist, sodass das drehbare Element (201) mindestens teilweise zwischen dem leitfähigen Teil und dem Trägerelement (202) angeordnet ist.

13. Raumsteuergerät nach einem der Ansprüche 1-12, wobei elektrische Komponenten der Leiterplatte (203, 303) angeordnet sind, um durch das Trägerelement (202, 302) abgeschirmt zu werden.

14. Raumsteuergerät nach einem der Ansprüche 1-13, wobei das Trägerelement eine Abschirmung für elektromagnetische Störung (EMI) und elektrostatische Entladung (ESD), und eine Abschirmung für Funkfrequenzkomponenten bereitstellt.

## Revendications

1. Dispositif de commande de pièce comprenant
une carte de circuit imprimé (203) et un élément rotatif (201, 301) pour commander un(des) ajustement(s) des conditions environnementales, l'élément rotatif (201, 301) étant raccordé de manière rotative à la carte de circuit imprimé (203) par l'intermédiaire d'un élément de support (202) comprenant des surfaces de contact coulissantes comprenant une surface latérale externe (3021) qui est disposée en contact avec l'élément rotatif (301) et/ou avec une bague de codage (304) configurée pour tourner avec l'élément rotatif (301), en relation avec l'élément de support (302), la bague de codage (304) étant disposée entre l'élément rotatif (301) et l'élément de support (302), et avec ladite surface latérale externe (3021) configurée pour correspondre au moins partiellement à une forme de la surface cylindrique interne de l'élément rotatif (201, 301), et lequel élément de support (202) est fixé à la carte de circuit imprimé (203),
l'élément de support (202) comprenant du plastique conducteur,
l'élément de support (202) étant raccordé à la terre de la carte de circuit imprimé (203), et
l'élément rotatif (201, 301) étant mis à la terre par l'intermédiaire de l'élément de support (202).

2. Dispositif de commande de pièce selon la revendication 1, l'élément rotatif (201) comprenant un matériau conducteur, éventuellement une portion, une partie circulaire ou un revêtement en matériau conducteur.

3. Dispositif de commande de pièce selon la revendication 1 ou 2, l'élément rotatif (201, 301) mis à la terre fournissant une protection contre l'interférence électromagnétique et la décharge électrostatique.

4. Dispositif de commande de pièce selon la revendication 1, la bague de codage (304) comprenant un matériau conducteur, éventuellement un plastique conducteur différent du plastique conducteur de l'élément de support.

5. Dispositif de commande de pièce selon l'une quelconque des revendications 1 à 4, la détection de position de rotation de l'élément rotatif (301) étant mise en oeuvre par l'intermédiaire d'une bague de codage (304).

6. Dispositif de commande de pièce selon l'une quelconque des revendications 1 à 5, l'élément rotatif (201) et l'élément de support (202) étant disposés au moins partiellement en contact, éventuellement par l'intermédiaire d'une bague de codage (304), de sorte que le contact fournit une mise à la terre de l'élément rotatif (201) par l'intermédiaire de l'élément de support (202), tout en permettant une rotation de l'élément rotatif (201) en relation avec l'élément de support (202).

7. Dispositif de commande de pièce selon l'une quelconque des revendications 1 à 6, l'élément de support comprenant une(des) surface(s) externe(s) verticale(s) et horizontale(s) disposée(s) pour former des surfaces de contact coulissantes (3021, 3022), qui sont disposées au moins partiellement en contact avec au moins des portions d'une surface interne cylindrique et une surface de bord de l'élément rotatif (301) ou d'une bague de codage (304).

8. Dispositif de commande de pièce selon l'une quelconque des revendications 1 à 7, comprenant un affichage (402) pour présenter l'(les) ajustement(s) du dispositif de commande de pièce, l'affichage (402) étant raccordé de manière non rotative au dispositif de commande de pièce et électriquement connecté à la carte de circuit imprimé du dispositif de commande de pièce.

9. Dispositif de commande de pièce selon la revendication 8, l'affichage (402) comprenant un pilote d'affichage et des connexions électriques, l'affichage (402), le pilote d'affichage et/ou les connexions électriques étant protégés par l'élément de support.

10. Dispositif de commande de pièce selon l'une quelconque des revendications 1 à 9, le dispositif de commande de pièce étant un thermostat.

11. Dispositif de commande de pièce selon l'une quelconque des revendications 1 à 10, comprenant un système de détection de rotation conçu pour détecter mécaniquement une rotation de l'élément rotatif (301).

12. Dispositif de commande de pièce selon l'une quelconque des revendications 1 à 11, comprenant une pièce circulaire conductrice fixée à un logement du dispositif de commande de pièce et disposée au moins partiellement autour de l'élément rotatif (201), de sorte que l'élément rotatif (201) est disposé au moins partiellement entre la pièce conductrice et l'élément de support (202).

13. Dispositif de commande de pièce selon l'une quelconque des revendications 1 à 12, les composants électriques de la carte de circuit imprimé (203, 303) étant disposés pour être protégés par l'élément de support (202, 302).

14. Dispositif de commande de pièce selon l'une quelconque des revendications 1 à 13, l'élément de support fournissant une protection contre l'interférence électromagnétique (EMI) et la décharge électrostatique (ESD), et une protection pour les composants de radiofréquence.
